Europäisches Patentamt

European Patent Office

Office européen des brevets

(19)

(11) **EP 1 482 572 A1**

(12) **EUROPEAN PATENT APPLICATION**

(43) Date of publication:
**01.12.2004 Bulletin 2004/49**

(51) Int Cl.7: **H01L 51/10**, H01L 21/28,
G09G 3/32, H05B 33/26,
G02F 1/1343

(21) Application number: **04012595.7**

(22) Date of filing: **27.05.2004**

(84) Designated Contracting States:
**AT BE BG CH CY CZ DE DK EE ES FI FR GB GR
HU IE IT LI LU MC NL PL PT RO SE SI SK TR**
Designated Extension States:
**AL HR LT LV MK**

(30) Priority: **29.05.2003 JP 2003153052
28.08.2003 JP 2003305285**

(71) Applicant: **SONY CORPORATION
Tokyo (JP)**

(72) Inventors:
• **Yokoyama, Seiichi
  Shinagawa-ku Tokyo (JP)**
• **Ohwada, Takuo
  Chuo-ku Tokyo (JP)**
• **Ishikawa, Norio
  Soka-shi Saitama (JP)**

(74) Representative: **Rupp, Christian, Dipl.Phys. et al
Mitscherlich & Partner
Patent- und Rechtsanwälte
Sonnenstrasse 33
80331 München (DE)**

(54) **Method of manufacturing a laminated structure, laminated structure, display device and display unit with laminated structure**

(57)     Provided is a method of manufacturing a laminated structure capable of being patterned into a favorable shape by preventing side etching. After an adhesive layer made of ITO or the like, a reflective layer made of silver or an alloy including silver, and a barrier layer made of ITO or the like are laminated in order on a substrate with a planarizing layer which is a base layer in between, a mask is formed on the barrier layer, and the adhesive layer, the reflective layer and the barrier layer are etched at once by using the mask to form a laminated structure. As an etching gas, for example, a gas including methane ($CH_4$) is preferable. The laminated structure is used as an anode, and an insulating film, an organic layer including a light-emitting layer and a common electrode as a cathode are laminated in order on the laminated structure so as to form an organic light-emitting device. The laminated structure can be used as a reflective electrode, a reflective film or wiring of a liquid crystal display.

FIG. 1

# Description

## BACKGROUND OF THE INVENTION

### 1. Field of the Invention

The present invention relates to a method of manufacturing a laminated structure which is suitable as a reflective electrode, a reflective film or wiring, and a laminated structure, a display device and a display unit which are manufactured through the method.

### 2. Description of the Related Art

In recent years, as one of flat panel displays, an organic light-emitting display using an organic light-emitting device has become a focus of attention. The organic light-emitting display is of a self-luminous type, so it is considered that the organic light-emitting display has advantages of a wide viewing angle, low power consumption and adequate response to high-definition high-speed video signals. Therefore, the development of the organic light-emitting displays toward practical utilization has been proceeding.

As the organic light-emitting device, for example, a laminate comprising a first electrode, an organic layer including a light-emitting layer, and a second electrode with a TFT (Thin Film Transistor), a planarizing layer and the like in between in order on a substrate is known. Light generated in the light-emitting layer may be extracted from the substrate side or the second electrode side.

As an electrode where light is extracted, in many cases, a transparent electrode made of an electrically conductive material with transparency such as a compound including indium (In), tin (Sn) and oxygen (O) (ITO; Indium Tin Oxide) is used. Various structures of the transparent electrode have previously been proposed. For example, in order to prevent an increase in cost due to an increase in the thickness of an ITO film, a transparent electrode including a laminate of a metal thin film made of silver (Ag) or the like and a high refractive index thin film made of zinc oxide (ZnO) or the like has been proposed (for example, refer to Japanese Unexamined Patent Application Publication No. 2002-334792). In the transparent electrode, the high refractive index thin film has a thickness of 5 nm to 350 nm, and the metal thin film has a thickness of 1 nm to 50 nm, so the high refractive index thin film is relatively thicker than the metal thin film, thereby the transparency of the transparent electrode is increased, and reflection by a surface of the metal thin film can be reduced by the high refractive index thin film.

In many cases, as an electrode where light is not extracted, various metal electrodes are used. For example, when light is extracted from the second electrode side, the first electrode as an anode is made of, for example, a metal such as chromium (Cr). Conventionally, for example, a first electrode with a two-layer structure including a metallic material layer made of chromium and a buffer thin film layer made of an oxide including chromium has been proposed, thereby the surface roughness of chromium of the metallic material layer is reduced by the buffer thin film layer (for example, refer to Japanese Unexamined Patent Application Publication No. 2002-216976).

When light is extracted from the second electrode side, light generated in the light-emitting layer may be directly extracted through the second electrode, or may be reflected by the first electrode once to be emitted through the second electrode. Conventionally, the first electrode is made of chromium or the like, so there is a problem that the light absorptance of the first electrode is large, thereby a loss of light reflected by the first electrode to be extracted is large. The light absorptance of the first electrode has a large influence on the organic light-emitting device, so when the light-emitting efficiency is lower, a larger amount of current is required in order to obtain the same intensity. An increase in the amount of driving current has a large influence on the life of the organic light-emitting device which is extremely important for practical use of the organic light-emitting device.

Therefore, for example, it is considered that the first electrode is made of silver (Ag) with the highest reflectance among metals or an alloy including silver. In this case, silver has extremely high reactivity, so in order to prevent deformation or corrosion, it is considered useful to dispose a buffer thin film layer or the like on a surface of a silver layer as in the case of the above conventional art.

Moreover, an organic film is formed directly on a top surface of such a first electrode, so it is required to remove as many impurities as possible. Further, after etching, a side surface of silver under the buffer thin film layer is exposed as an electrode, so when a mask (photoresist) remained after etching is removed with a remover, it is required to prevent silver or a silver alloy from being leached out.

However, in a wet etching technique conventionally used for patterning silver, when a laminated structure including the buffer thin film layer disposed on the surface of the silver layer is used as the first electrode, a difference in etching rate between the silver layer and the buffer thin film layer results in side etching of the silver layer, thereby a defect in the shape of the first electrode may cause a defect in the organic light-emitting device. Moreover, oxygen or a chemical solution is prone to be remained in a hole made by side etching of the silver layer, so it has a large influence on the life of the organic light-emitting device.

As a photoresist remover used after etching the first electrode, a combination of an organic solvent and aminoalcohol (for example, refer to Japanese Unexamined Patent Application Publication No. Hei 5-281753 and US Patent No. 5480585) has been proposed, and as aminoalcohol, 2-aminoethanol is generally used, because 2-aminoethanol has a high removing propety and is inexpensive.

However, in the case where 2-aminoethanol is used, the photoresist on the buffer thin film layer cannot be removed completely, so it is considered that remained impurities may cause defects such as a dark point defect. Further, when the photoresist remained after etching silver or the silver alloy is removed with a photoresist remover including 2-aminoethanol, silver or the silver alloy exposed to a side surface of the first electrode may be corroded by the remover, thereby resulting in a defect.

SUMMARY OF THE INVENTION

In view of the foregoing, it is a first object of the invention to provide a method of manufacturing a laminated structure capable of preventing side etching resulting from a difference in etching rate on etching a plurality of layers so as to have a favorable shape after etching, a laminated structure, a display device and a display unit which are manufactured through the method,

It is a second object of the invention to provide a method of manufacturing a laminated structure capable of reducing defects and obtaining high reliability by using a remover which has no corrosivity to silver and a silver alloy of the plurality of layers and an excellent removing property, and is capable of removing impurities causing a dark point defect on removing a mask (photoresist film) after etching the plurality of layers at once, a laminated structure, a display device and a display unit which are manufactured through the method,

A method of manufacturing a laminated structure according to the invention comprises the steps of: laminating a plurality of layers on a substrate; forming a mask on the plurality of layers; and etching the plurality of layers at once by using the mask. The step of forming the plurality of layers includes the steps of: forming an adhesive layer on the substrate; forming a silver layer in contact with a surface of the adhesive layer; and forming a barrier layer for protecting the silver layer in contact with a surface of the silver layer.

As a layer among the plurality of layers, a silver layer made of silver (Ag) or an alloy including silver can be formed, and at this time, as a remover used after etching with a photoresist mask, a nonaqueous remover including an organic amino compound including at least one kind selected from the group consisting of diethylenetriamine, 2-(2-aminoethylamino)ethanol, 2-(2-aminoethylamino)-2propanol, N-(3-aminopropyl)-N-(2-hydroxyethyl)-2-aminoethanol, 2-(2-aminoethoxy)ethanol, dipropylenetriamine, triethylenetetramine and formalin, and one kind or two or more kinds of polar organic solvents is preferable. At this time, the total content of the organic amino compound in the remover is preferably within a range of 20% by mass to 50% by mass inclusive, and more specifically, the polar organic solvent preferably includes at least one kind selected from the group consisting of 1,3-dimethyl-2-imidazolidinone and N-methyl-2-pyrrolidinone.

A laminated structure according to the invention is formed through forming an adhesive layer, a silver layer made of silver (Ag) or an alloy including silver and a barrier layer in order on a substrate, forming a mask on the barrier layer, and etching the barrier layer, the silver layer and the adhesive layer at once by using the mask.

A display device according to the invention comprises a laminated structure formed through forming an adhesive layer, a silver layer made of silver (Ag) or an alloy including silver and a barrier layer in order on a substrate, forming a mask on the barrier layer, and etching the barrier layer, the silver layer and the adhesive layer at once by using the mask.

A display unit according to the invention comprises a plurality of display devices on a substrate, wherein each of the display devices comprises a laminated structure formed through forming an adhesive layer, a silver layer made of silver (Ag) or an alloy including silver and a barrier layer in order on a substrate, forming a mask on the barrier layer, and etching the barrier layer, the silver layer and the adhesive layer at once by using the mask.

In the method of manufacturing a laminated structure according to the invention, after a plurality of layers are laminated on the substrate, a mask is formed on the plurality of the layers. Next, the plurality of layers are etched at once by using the mask. The mask is removed with a remover.

In the laminated structure, the display device and the display unit according to the invention, side etching of the silver layer can be prevented by etching the barrier layer, the silver layer and the adhesive layer at once. At this time, when the remover for the mask includes water, a component included in the remover reacts with water to be alkalified, and the alkalified component corrodes a side surface of the silver layer or enters a grain boundary to accelerate corrosion in pixels of the display device, so defects will increase. However, when the mask is removed with the above nonaqueous remover, silver in the exposed side surface of the silver layer is not corroded, and the mask and impurities on the surface of the barrier layer is completely removed, so reliability can be improved.

Other and further objects, features and advantages of the invention will appear more fully from the following description.

BRIEF DESCRIPTION OF THE DRAWINGS

FIG. 1 is a sectional view of a display unit according to a first embodiment of the invention;
FIG. 2 is an enlarged sectional view of an organic light-emitting device shown in FIG. 1;

FIG. 3 is an enlarged sectional view of an organic light-emitting device shown in FIG. 1;

FIGs. 4A and 4B are sectional views showing steps in a method of manufacturing the display unit shown in FIG. 1;

FIGs. 5A through 5C are sectional views showing steps following the steps in FIGs. 4A and 4B;

FIGs. 6A and 6B are sectional views showing steps following the steps in FIGs. 5A through 5C;

FIGs. 7A and 7B are sectional views showing steps following the steps in FIGs. 6A and 6B;

FIG. 8 is a sectional view showing a step following the steps in FIGs. 7A and 7B;

FIG. 9 is a sectional view showing a step following the step in FIG. 8;

FIG. 10 is a sectional view showing a step following the step in FIG. 9;

FIG. 11 is a sectional view showing a step following the step in FIG. 10;

FIG. 12 is a sectional view showing a step following the step in FIG. 11;

FIGs. 13A and 13B are sectional views showing steps following the step in FIG. 12;

FIG. 14 is a sectional view showing a step following the steps in FIGs. 13A and 13B;

FIG. 15 is a sectional view of a display unit according to a second embodiment of the invention;

FIG. 16 is a sectional view of a display unit according to a modification of the invention; and

FIG. 17 is a sectional view of a display unit according to another modification of the invention.

## DETAILED DESCRIPTION OF THE PREFERRED EMBODIMENTS

Preferred embodiments of the present invention will be described in more detail below referring to the accompanying drawings.

[First Embodiment]

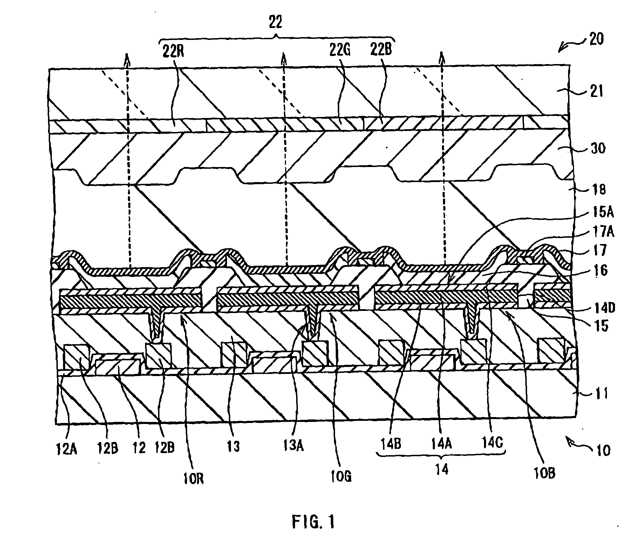

FIG. 1 shows a sectional view of a display unit according to a first embodiment of the invention. The display unit is used as an ultra-thin organic light-emitting display, and in the display unit, a driving panel 10 and a sealing panel 20 face each other, and the whole facing surfaces thereof are bonded together with an adhesive layer 30 made of a thermosetting resin. The driving panel 10 includes, for example, an organic light-emitting device 10R emitting red light, an organic light-emitting device 10G emitting green light and an organic light-emitting device 10B emitting blue light disposed in order in a matrix shape as a whole on a substrate 11 made of an insulating material such as glass with a TFT 12 and a planarizing layer 13 in between.

A gate electrode (not shown) of the TFT 12 is connected to a scanning circuit (not shown), and a source and a drain (both not shown) are connected to wiring 12B through an interlayer insulating film 12A made of, for example, silicon oxide, PSG (phosphosilicate glass) or the like. The wiring 12B is connected to the source and the drain of the TFT 12 through a connecting hole (not shown) disposed in the interlayer insulating film 12A to function as a signal line. The wiring 12B is made of, for example, aluminum (Al) or an aluminum (Al) copper (Cu) alloy. The structure of the TFT 12 is not specifically limited, and may be of a bottom gate structure or a top gate structure.

The planarizing layer 13 is provided to planarize a surface of the substrate 11 where the TFT 12 is formed so as to form each layer of the organic light-emitting devices 10R, 10G and 10B with uniform thicknesses. In the planarizing layer 13, a connecting hole 13A is disposed to connect a laminated structure 14 of each of the organic light-emitting devices 10R, 10G and 10B to the wiring 12B. In the planarizing layer 13, a minute connecting hole 13A is formed, so the planarizing layer 13 is preferably made of a material with high pattern accuracy. As the material of the planarizing layer 13, an organic material such as polyimide or an inorganic material such as silicon oxide ($SiO_2$) can be used. In the embodiment, the planarizing layer 13 is made of, for example, an organic material such as polyimide.

The organic light-emitting devices 10R, 10G and 10B each include, for example, the laminated structure (first electrode) 14 as an anode, an insulating film 15, an organic layer 16 including a light-emitting layer and a common electrode (second electrode) 17 as a cathode laminated in order from the substrate 11 with the TFT 12 and the planarizing layer 13 in between. A protective film 18 is formed on the common electrode 17 if necessary.

The laminated structure 14 also has a function as a reflective layer, so the laminated structure 14 preferably has as high reflectance as possible so as to enhance light-emitting efficiency. Therefore, the laminated structure 14 preferably includes a reflective layer 14A made of, for example, silver (Ag) or an alloy including silver, because silver has the highest reflectance among metals, so an absorption loss of light in the reflective layer 14A can be reduced. Although the reflective layer 14A made of silver is preferable, because the reflective layer 14A has the highest reflectance, the reflective layer 14A made of an alloy including silver and another metal is more preferable, because chemical stability and processing accuracy can be enhanced, and adhesion with an adhesive layer 14B and a barrier layer 14C which will be described later can be improved. Silver has extremely high reactivity, low processing accuracy and low adhesion, so it is extremely difficult to handle silver.

The reflective layer 14A preferably has a thickness in a laminate direction (hereinafter simply referred to as "thickness") of, for example, 50 nm to 200 nm inclusive. It is because when the thickness is within the range, high reflectance can be obtained. Further, the reflective layer 14A more preferably has a thickness of 50 nm to 150 nm inclusive. It is because when the thickness of the reflective layer 14A is reduced, the surface roughness of the reflective layer 14A can be reduced, thereby the thickness of the barrier layer 14C which will be described later can be reduced to increase light extraction efficiency. Moreover, it is because when the thickness of the reflective layer 14A is reduced, an increase in the surface roughness due to crystallization of the reflective layer 14A by heat processing during manufacturing can be reduced, thereby an increase in defects of the barrier layer 14C due to the increased surface roughness of the reflective layer 14A can be prevented.

In the laminated structure 14, for example, the adhesive layer 14B, the reflective layer 14A and the barrier layer 14C are preferably laminated in this order from the substrate 11. The adhesive layer 14B is disposed between a flat surface 11A of the substrate 11 and the reflective layer 14A to prevent separation of the reflective layer 14A from the planarizing layer 13. The barrier layer 14C has functions as a protective film, that is, functions of preventing silver or an alloy including silver of the reflective layer 14A from reacting with oxygen or sulfur in air, and reducing damage to the reflective layer 14A during a manufacturing step after forming the reflective layer 14A. Moreover, the barrier layer 14C has a function as a surface planarizing film which reduces the surface roughness of the reflective layer 14A made of silver or an alloy including silver.

As will be described later, the laminated structure 14 is formed through forming the adhesive layer 14B, the reflective layer 14A and the barrier layer 14C in order on the substrate 11, forming a mask on the barrier layer 14C, and etching the barrier layer 14C, the reflective layer 14A and the adhesive layer 14B at once by using the mask. The shape of a sidewall surface 14D of the laminated structure 14 is not limited to a continuous surface shown in FIG. 1, and the sidewall surface 14D may have a nonuniform shape such as a partly stepped shape, a polygonal-line shape, a curved shape or a shape of connected curves. Further, the sidewall surface 14D may be perpendicular or diagonal to the substrate 11 or the planarizing layer 13.

The barrier layer 14C is preferably made of, for example, a metal compound or a conductive oxide including at least one kind selected from the group of elements consisting of indium (In), tin (Sn) and zinc (Zn). More specifically, the barrier layer 14C is preferably made of at least one kind selected from the group consisting of a compound including indium (In), tin (Sn) and oxygen (O) (ITO; indium tin oxide), a compound including indium (In), zinc (Zn) and oxygen (O) (IZO; indium zinc oxide), indium oxide ($In_2O_3$), tin oxide ($SnO_2$) and zinc oxide (ZnO). It is because by using any of these materials as the barrier layer 14C, the surface planarization of the laminated structure 14 can be improved, so each layer of the organic layer 16 can have a uniform thickness, thereby a possibility of a short circuit between the laminated structure 14 and the common electrode 17 due to lack of thickness of the organic layer 16 can be eliminated, and specifically when a resonator structure which will be described later is formed, the occurrence of color unevenness in pixels can be prevented to enhance color reproducibility. Moreover, it is because the materials have extremely small light absorption in a visible light range, so an absorption loss in the barrier layer 14C can be reduced to enhance light extraction efficiency. Further, the barrier layer 14C also has a function as a work function adjustment layer which enhances efficiency of hole injection into the organic layer 16, so the barrier layer 14C is preferably made of a material having a higher work function than the reflective layer 14A. In terms of productivity, ITO and IZO are specifically preferable as the barrier layer 14C.

In order for the barrier layer 14C to secure the above described functions as a protective film, the thickness of the barrier layer 14C is preferably within a range of 1 nm to 50 nm inclusive, and in order to enhance light extraction efficiency, the thickness is more preferably within a range of 3 nm to 15 nm inclusive.

For example, the adhesive layer 14B is preferably made of a metal compound or a conductive oxide including at least one kind selected from the group of elements consisting of indium (In), tin (Sn) and zinc (Zn). More specifically, the adhesive layer 14B is preferably made of at least one kind selected from the group consisting of a compound including indium (In), tin (Sn) and oxygen (O) (ITO; indium tin oxide), a compound including indium (In), zinc (Zn) and oxygen (O) (IZO; indium zinc oxide), indium oxide ($In_2O_3$), tin oxide ($SnO_2$) and zinc oxide (ZnO). It is because when the adhesive layer 14B is etched after etching the barrier layer 14C and the reflective layer 14A, without forming a new mask or changing an etching gas, patterning can be carried out with the same mask and the same etching gas. Moreover, the adhesive layer 14B and the barrier layer 14C more preferably include at least one same element selected from the group consisting of indium (In), tin (Sn) and zinc (Zn), and more preferably include indium (In).

The adhesive layer 14B preferably has an enough thickness to prevent a hillock or separation of the reflective layer 14A. More specifically, the adhesive layer 14B preferably has a thickness of 5 nm to 50 nm inclusive, and more preferably 10 nm to 30 nm inclusive.

In the embodiment, the adhesive layer 14B and the barrier layer 14C are made of, for example, ITO. However, for example, the adhesive layer 14B can be made of ITO, and the barrier layer 14C can be made of IZO. Alternatively, the adhesive layer 14B and the barrier layer 14C may be made of IZO. Further, the adhesive layer 14B may be made of ZnO, and the barrier layer 14C may be made of ITO.

The insulating film 15 is provided to secure insulation between the laminated structure 14 and the common electrode 17, and to accurately form a desired shape of a light-emitting region in each of the organic light-emitting devices 10R, 10G and 10B. The insulating film 15 has, for example, a thickness of approximately 600 nm, and is made of an insulating material such as silicon oxide or polyimide. The insulating film 15 is formed so as to be laid from a sidewall surface 14D to a peripheral portion of the top surface in the laminated structure 14, and an aperture portion 15A is disposed corresponding to a light-emitting region in the laminated structure 14, that is, each of the organic light-emitting devices 10R, 10G and 10B.

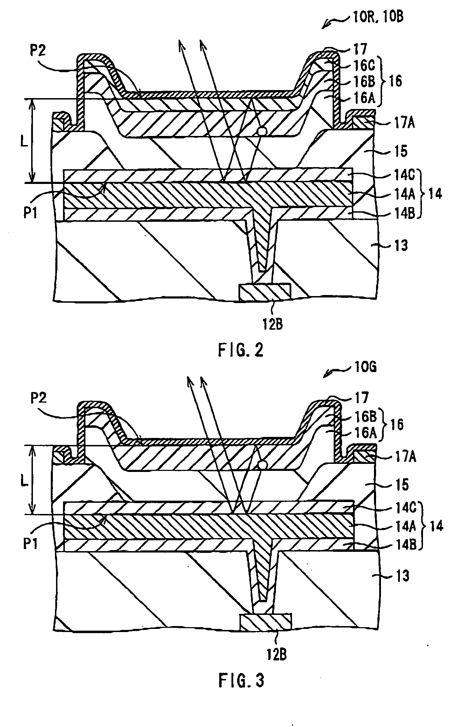

The organic layer 16 has a different structure depending upon colors emitted from the organic light-emitting devices 10R, 10G and 10B. FIG. 2 shows an enlarged view of the organic layer 16 in the organic light-emitting devices 10R and 10B. The organic layer 16 of each of the organic light-emitting devices 10R and 10B has a structure in which a hole transport layer 16A, a light-emitting layer 16B and an electron transport layer 16C are laminated in this order from the laminated structure 14. The hole transport layer 16A enhances the efficiency of hole injection into the light-emitting layer 16B. In the embodiment, the hole transport layer 16A also serves as a hole injection layer. The light-emitting layer 16B generates light through applying an electric field to recombine electrons and holes, and emits the light in a region corresponding to the aperture portion 15A of the insulating film 15. The electron transport layer 16C enhances the efficiency of electron injection into the light-emitting layer 16B.

The hole transport layer 16A of the organic light-emitting device 10R has, for example, a thickness of approximately 45 nm, and made of bis[(N-naphthyl)-N-phenyl]benzidine ($\alpha$-NPD). The light-emitting layer 16B of the organic light-emitting device 10R has, for example, a thickness of approximately 50 nm, and is made of 2,5-bis[4-[N-(4-methoxyphenyl)-N-phenylamino]]styrylbenzene-1,4-dicarbonitrile (BSB). The electron transport layer 16C of the organic light-emitting device 10R has, for example, a thickness of approximately 30 nm, and is made of 8-quinolinol aluminum complex ($Alq_3$).

The hole transport layer 16A of the organic light-emitting device 10B has, for example, a thickness of approximately 30 nm, and is made of $\alpha$-NPD. The light-emitting layer 16B of the organic light-emitting device 10B has, for example, a thickness of approximately 30 nm, and is made of 4,4'-bis(2,2'-diphenyl vinyl)biphenyl (DPVBi). The electron transport layer 16C of the organic light-emitting device 10B has, for example, a thickness of approximately 30 nm, and is made of $Alq_3$.

FIG. 3 shows an enlarged view of the organic layer 16 in the organic light-emitting device 10G. The organic layer 16 of the organic light-emitting device 10G has a structure in which a hole transport layer 16A and a light-emitting layer 16B are laminated in this order from the laminated structure 14. The hole transport layer 16A also serves as a hole injection layer, and the light-emitting layer 16B also serves as an electron transport layer.

The hole transport layer 16A of the organic light-emitting device 10G has, for example, a thickness of approximately 50 nm, and is made of $\alpha$-NPD. The light-emitting layer 16B of the organic light-emitting device 10G has, for example, a thickness of approximately 60 nm, and is made of $Alq_3$ mixed with 1% by volume of Coumarin6 (C6).

The common electrode 17 shown in FIGs. 1, 2 and 3 has, for example, a thickness of approximately 10 nm, and is made of a metal such as silver (Ag), aluminum (Al), magnesium (Mg), calcium (Ca) or sodium (Na), or an alloy thereof. In the embodiment, the common electrode 17 is made of, for example, an alloy of magnesium (Mg) and silver (MgAg alloy).

The common electrode 17 is formed so that the organic light-emitting devices 10R, 10G and 10B are covered with the common electrode 17. An auxiliary electrode 17A is preferably disposed on the insulating film 15 to reduce a voltage drop in the common electrode 17. The auxiliary electrode 17A is disposed in gaps between the organic light-emitting devices 10R, 10G and 10B, and an end portion thereof is connected to a trunk-shaped auxiliary electrode (not shown) which is a bus formed so as to surround a region where the organic light-emitting devices 10R, 10G and 10B are disposed in a peripheral portion of the substrate 11. The auxiliary electrode 17A and the trunk-shaped auxiliary electrode have a single layer structure or a laminated structure made of an electrically conductive material with low resistance such as aluminum (Al) or chromium (Cr).

The common electrode 17 also serves as a semi-transparent reflective layer. More specifically, each of the organic light-emitting devices 10R, 10G and 10B has a resonator structure in which assuming that an interface between the reflective layer 14A and the barrier layer 14C in the laminated structure 14 and an interface of the common electrode 17 on a side closer to the light-emitting layer 16B are a first end portion P1 and a second end portion P2, respectively, and the organic layer 16 and the barrier layer 14C are a resonant portion, light generated in the light-emitting layer 16B is resonated to be extracted from the second end portion P2. The organic light-emitting devices 10R, 10G and 10B preferably have such a resonator structure, because multiple interference of the light generated in the light-emitting layer 16B is produced, and the structure functions as a kind of narrow-band filter, thereby the half-value width of the spectrum of extracted light can be reduced, and color purity can be improved. Moreover, external light entering from the sealing panel 20 can be attenuated by the multiple interference, and the reflectance of the external light on the organic light-emitting devices 10R, 10G and 10B can become extremely small by a combination of a color filter 22 (refer to FIG. 1) which will be described later.

For the purpose, it is preferable that an optical distance L between the first end portion P1 and the second end portion P2 of the resonator satisfies Mathematical Formula 1 so that a resonant wavelength of the resonator (a peak wavelength of the spectrum of light to be extracted) matches a peak wavelength of the spectrum of light desired to be extracted. Actually, the optical distance L is preferably selected to be a positive minimum value satisfying Mathematical Formula 1.

(Mathematical Formula 1)

$$(2L)/\lambda + \Phi/(2\pi) = m$$

(In the formula, L represents an optical distance between the first end portion P1 and the second end portion P2, $\Phi$ represents the sum of a phase shift $\Phi_1$ of reflected light generated in the first end portion P1 and a phase shift $\Phi_2$ of reflected light generated in the second end portion P2 ($\Phi=\Phi_1+\Phi_2$) (rad), $\lambda$ represents a peak wavelength of the spectrum of light desired to be extracted from the second end portion P2, and m is an integer to make L a positive value. Further, in Mathematical Formula 1, the units of L and $\lambda$ may be the same, for example, (nm).)

The protective film 18 shown in FIG. 1 has, for example, a thickness of 500 nm to 10000 nm inclusive, and is a passivation film made of a transparent dielectric. The protective film 18 is made of, for example, silicon oxide ($SiO_2$), silicon nitride (SiN) or the like.

As shown in FIG. 1, the sealing panel 20 is placed on a side of the driving panel 10 closer to the common electrode 17, and has a sealing substrate 21 which seals the organic light-emitting devices 10R, 10G and 10B with the adhesive layer 30. The sealing substrate 21 is made of a material transparent to light generated in the organic light-emitting devices 10R, 10G and 10B such as glass. For example, the color filter 22 is disposed on the sealing substrate 21 to extract light generated in the organic light-emitting devices 10R, 10G and 10B, and to absorb external light reflected by the organic light-emitting devices 10R, 10G and 10B and wiring therebetween, thereby the contrast is improved.

The color filter 22 may be disposed on either side of the sealing substrate 21, but the color filter 22 is preferably disposed on a side closer to the driving panel 10, because the color filter 22 is not exposed to the surface, and can be protected by the adhesive layer 30. The color filter 22 includes a red filter 22R, a green filter 22G and a blue filter 22B, which are disposed corresponding to the organic light-emitting devices 10R, 10G and 10B, respectively.

The red filter 22R, the green filter 22G and the blue filter 22B each have, for example, a rectangular shape, and are formed with no space in between. The red filter 22R, the green filter 22G and the blue filter 22B each are made of a resin mixed with pigments, and by the selection of the pigments, the light transmittance in a targeted wavelength of red, green or blue is adjusted to be higher, and the light transmittance in other wavelengths is adjusted to be lower.

Moreover, a wavelength range with high transmittance in the color filter 22 matches the peak wavelength $\lambda$ of the spectrum of light to be extracted from the resonator structure. Thereby, among external light entering from the sealing panel 20, only light having a wavelength equivalent to the peak wavelength $\lambda$ of the spectrum of light to be extracted passes through the color filter 22, and external light with other wavelengths can be prevented from entering into the organic light-emitting devices 10R, 10G and 10B.

The display unit can be manufactured through the following steps, for example.

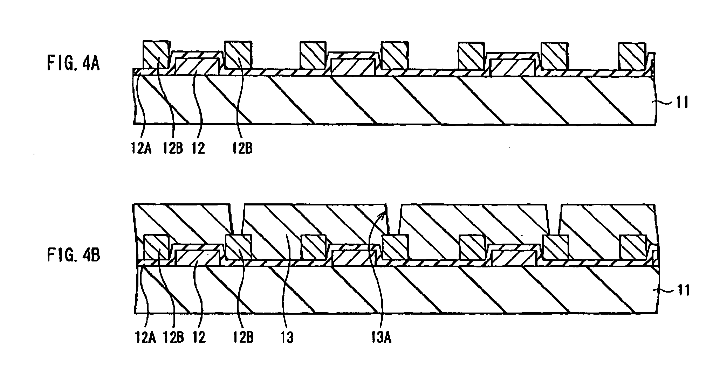

FIGs. 4A through 14 show steps in a method of manufacturing the display unit in order. At first, as shown in FIG. 4A, the TFT 12, the interlayer insulating film 12A and the wiring 12B are formed on the substrate 11 made of the above-described materials.

Next, as shown in FIG. 4B, the planarizing layer 13 made of the above-described material is formed all over the substrate 11 by, for example, a spin coat method, and then while the planarizing layer 13 is patterned into a predetermined shape by exposure and development, the connecting hole 13A is formed. After that, in order to imidize polyimide, the planarizing layer 13 is baked at, for example, 320°C with a clean baking furnace.

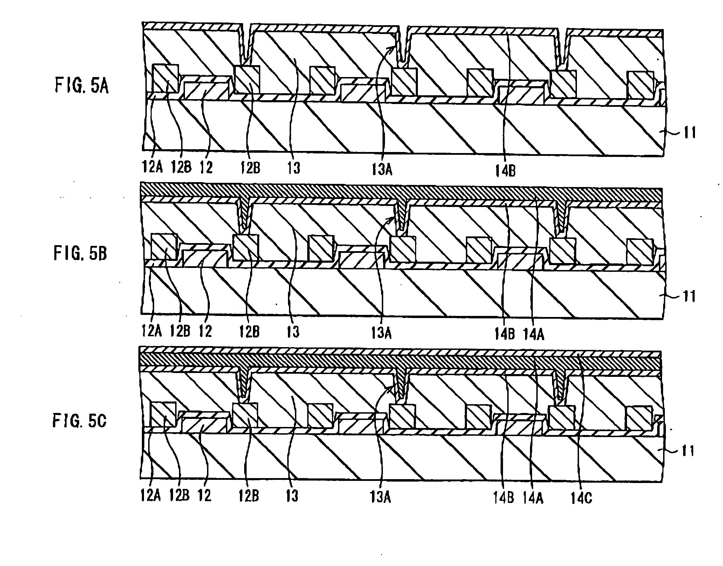

Next, as shown in FIG. 5A, the adhesive layer 14B made of, for example, ITO with a thickness of 20 nm is formed on the flat surface 11A formed by the planarizing layer 13 through, for example, sputtering.

After that, as shown in FIG. 5B, the reflective layer 14A made of, for example, an alloy including silver with a thickness of 100 nm is formed on the adhesive layer 14B through, for example, sputtering. Thus, the reflective layer 14A is formed on the planarizing layer 13 with the adhesive layer 14B in between, thereby the reflective layer 14A can be prevented from being separated from the planarizing layer 13 as a base layer. Moreover, the entry of an etching solution or air from a separated portion of the reflective layer 14A can be prevented, thereby silver or an alloy including silver of the reflective layer 14A can be prevented from reacting with oxygen or sulfur included in the etching solution or the air.

Next, as shown in FIG. 5C, the barrier layer 14C made of, for example, ITO with a thickness of 10 nm is formed on the reflective layer 14A through, for example, sputtering. Thus, after forming the reflective layer 14A, the barrier layer 14C is immediately formed, thereby silver or the alloy including silver of the reflective layer 14A can be prevented from reacting with oxygen or sulfur in air, and during a manufacturing step after forming the reflective layer 14A, damage to the reflective layer 14A can be reduced, and an interface between the reflective layer 14A and the barrier layer 14C can be maintained clean.

After forming the adhesive layer 14B, the reflective layer 14A and the barrier layer 14C, as shown in FIG. 6A, a mask 41 made of, for example, a photoresist film is formed on the barrier layer 14C through, for example, lithography.

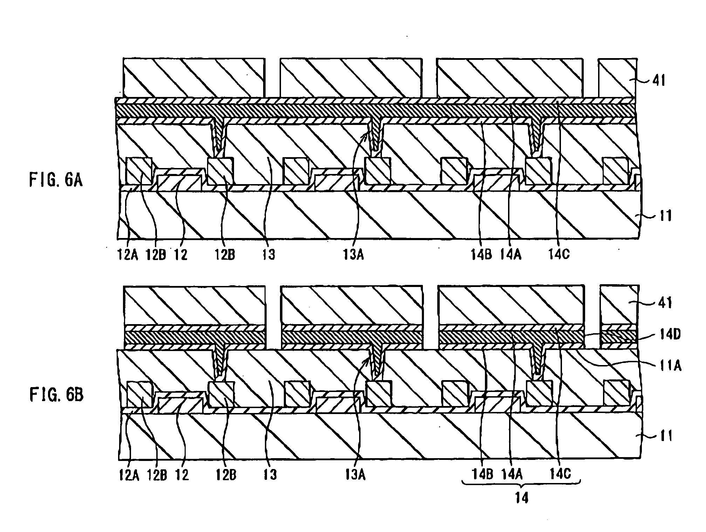

Next, as shown in FIG. 6B, the barrier layer 14C, the reflective layer 14A and the adhesive layer 14B are etched at once by using the mask 41.

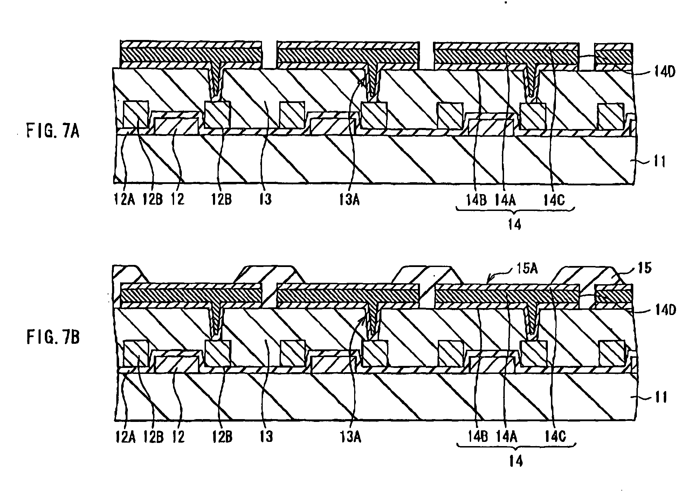

After that, as shown in FIG. 7A, the mask 41 is removed with the remover. The remover suitable for the embodiment is a photoresist remover including the following materials.

The remover is a mixed solution including one kind or two or more kinds of organic amino compounds selected from the group consisting of compounds represented by Chemical Formula 1, compounds represented by Chemical Formula 2 and compounds represented by Chemical Formula 3, and one kind or two or more kinds of polar organic solvents and not including water. Further, one kind or two or more kinds of anticorrosives selected from the group consisting of pyrocatechol, hydroquinone, pyrogallol, gallic acid and gallate can be added to the remover.

(Chemical Formula 1)

$$NH_2\text{-A-Y-B-Z}$$

(In the formula, A and B are linear or branched alkylene groups which are independent of each other and have 1 to 5 carbon atoms, Y is NH or O, and Z is $NH_2$, OH, $NH\text{-D-}NH_2$ (herein D is a linear or branched alkylene group having 1 to 5 carbon atoms).)

(Chemical Formula 2)

$$NH_2\text{-A-N(-B-OH)}_2$$

(In the formula, A and B are the same as those in Chemical Formula 1.)

(Chemical Formula 3)

(In the formula, R is H, an alkyl group having 1 to 5 carbon atoms, a hydroxyalkyl group having 1 to 5 carbon atoms, or an aminoalkyl group having 1 to 5 carbon atoms.)

When the mask (photoresist film) remained after patterning the laminated structure including silver and/or a alloy including silver is removed, a specific anticorrosive which will be described later is added to the organic amino compound selected from the group consisting of the above-described compounds represented by Chemical Formulas 1, 2 and 3, thereby a property of removing the photoresist and an altered photoresist layer in the organic amino compound can be improved, and corrosivity of the organic amino compound to silver and an alloy including silver can be reduced.

Herein, the number of carbon atoms of A and B in Chemical Formulas 1 and 2 is preferably 2 to 10 in total, and more preferably 2 to 6 in total in terms of a photoresist removing property and corrosivity to silver.

Among these organic amino compounds, diethylenetriamine, 2-(2-aminoethylamino)ethanol, 2-(2-aminoethylamino)-2propanol, N-(3-aminopropyl)-N-(2-hydxoxyethyl)-2-aminoethanol, 2-(2-aminoethoxy)ethanol, dipropylenetriamine, triethylenetetramine, formalin are preferable, and specifically, 2-(2-aminoethozy) ethanol is preferable as aminoalcohol with a high property of removing the photoresist and an altered photoresist layer and small corrosivity to silver and an alloy including silver.

Moreover, the total content of the organic amino compound is preferably within a range of 20% by mass to 50% by mass in terms of the property of removing the photoresist and the altered photoresist layer and corrosivity to silver and an alloy including silver. When the content is less than 20% by mass, the property of removing the altered photoresist layer declines, and when the content is larger than 50% by mass, the corrosivity to silver and the alloy including silver becomes an issue.

Moreover, as the polar organic solvent mixed with the above organic amino compound, ether-based solvents such as ethylene glycol monomethyl ether, ethylene glycol monoethyl ether, ethylene glycol monopropyl ether, ethylene glycol monobutyl ether, diethylene glycol monobutyl ether, propylene glycol monomethyl ether, propylene glycol monoethyl ether, propylene glycol monopropyl ether, propylene glycol monobutyl ether, dipropylene glycol monomethyl ether, dipropylene glycol monoethyl ether, dipropylene glycol monopropyl ether, dipropylene glycol monobutyl ether, diethylene glycol dimethyl ether and dipropylene glycol dimethyl ether, amide-based solvents such as formamide, monomethylformamide, dimethylformamide, monoethylformamide, diethylformamide, acetamide, monomethylacetamide, dimethylacetamide, monoethylacetamide, diethylacetamide, pyrrolidinone-based solvents such as N-methyl-2-pyrrolidinone and N-ethylpyrrolidinone, alcohol-based solvents such as methyl alcohol, ethyl alcohol, propyl alcohol, isopropyl alcohol, ethylene glycol and propylene glycol, sulfoxide solvents such as dimethyl sulfoxide, imidazolidinone-based solvents such as 1,3-dimethyl-2-imidazolidinone, 1,3-diethyl-2-imidazolidinone and 1,3-diisopropyl-2-imidazolidinone, and lactone-based solvents such as γ -butyrolactone and γ -valerolactone are cited.

Among them, 1,3-dimethyl-2-imidazolidinone, 1,3-diethyl-2-imidazolidinone, 1,3-diisopropyl-2-imidazolidinone, N-methyl-2-pyrrolidinone, N-ethylpyrrolidinone, diethylene glycol monobutyl ether, propylene glycol and dimethyl sulfoxide are preferable as the polar organic solvent in the embodiment, and in terms of a property of removing the altered photoresist layer, 1,3-dimethyl-2-imidazolidinone, N-methyl-2-pyrrolidinone, diethylene glycol monobutyl ether, propylene glycol and dimethyl sulfoxide are preferable, and 1,3-dimethyl-2-imidazolidinone and N-methyl-2-pyrrolidinone are more preferable.

As the anti-corrosive, organic acids such as aminoacetic acid and acetic acid, phloroglucinol, resorcinol, phenol, benzotriazole, pyrocatechol, hydroquinone, gallic acid, gallate and pyrogallol are cited, and when they are added, corrosivity to silver and the alloy including silver can be further reduced.

As described above, as a preferred example of the organic amino compound, 2-(2-aminoethoxy)ethanol or the like is cited; however, as other organic amino compounds, monoethanolamine, diethanolamine, triethanolamine, N,N-dimethylethanolamine and the like are cited. However, among them, in diethanolamine, triethanolamine, N,N-dimethylethanolamine and the like, corrosivitiy to silver and the alloy including silver is relatively insignificant, but a low property of removing the altered photoresist layer becomes an issue. On the other hand, monoethanolamine has a high removing property, but there is a problem that monoethanolamine corrodes silver and the alloy including silver.

Therefore, when monoethanolamine is used as the organic amino compound, in addition to the polar organic solvent, an anti-corrosive is necessary, and specifically when pyrocatechol, hydroquinone, gallic acid, gallate or pyrogallol among the above-described anti-corrosives is added to the organic amino compound, a high removing property can be obtained, and the problem of the corrosivity to silver and the alloy including silver can be overcome.

As the polar organic solvent mixed with monoethanolamine, ether-based solvents such as ethylene glycol monomethyl ether, ethylene glycol monoethyl ether, ethylene glycol monopropyl ether, ethylene glycol monobutyl ether, diethylene glycol monobutyl ether, propylene glycol monomethyl ether, propylene glycol monoethyl ether, propylene glycol monopropyl ether, propylene glycol monobutyl ether, dipropylene glycol monomethyl ether, dipropylene glycol monoethyl ether, dipropylene glycol monopropyl ether, dipropylene glycol monobutyl ether, diethylene glycol dimethyl ether and dipropylene glycol dimethyl ether, amide-based solvents such as formamide, monomethylformamide, dimethylformamide, monoethylformamide, diethylformamide, acetamide, monomethylacetamide, dimethylacetamide, monoethylacetamide and diethylacetamide, pyrrolidinone-based solvents such as N-methyl-2-pyrrolidinone and N-ethylpyrrolidinone, alcohol-based solvents such as methyl alcohol, ethyl alcohol, propyl alcohol, isopropyl alcohol, ethylene glycol and propylene glycol, sulfoxide-based solvents such as dimethyl sulfoxide, imidazolidinone-based solvents such as 1,3-dimethyl-2-imidazolidinone, 1,3-diethyl-2-imidazolidinone and 1,3-diisopropyl-2-imidazolidinone, lactone-based solvents such as γ-butyrolactone and γ-valerolactone are cited. N-methyl-2-pyrrolidinone and/or 1,3-dimethyl-2-imidazolidinone are preferable.

Thus, various nonaqueous photoresist removers can be used. however, in the embodiment, for example, a mixture including 20% to 40% by mass of one kind of aminoalcohol, 10% to 30% by mass of one kind of the polar organic solvent, and the remaining amount of another kind of polar organic solvent is used. Thereby, the mask 41 (photoresist) remained on the barrier layer 14C can be removed, and corrosion of silver and the alloy including silver constituting the reflective layer 14A exposed to a side surface can be minimized, so defects such as a dark point defect in the case of using as a display unit can be reduced so as to improve reliability.

Referring back to FIGs. 7A and 7B, after the mask 41 is removed, as shown in FIG. 7B, the insulating film 15 with the above-described thickness is formed all over the substrate 11 through, for example, CVD (chemical vapor deposition), and a portion of the insulating film 15 corresponding to a light-emitting region is selectively removed through, for example, lithography to form the aperture portion 15A.

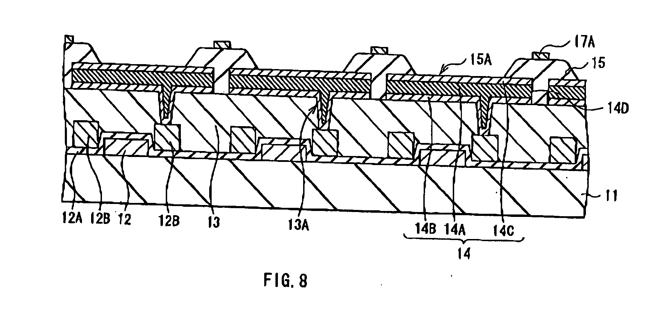

Next, as shown in FIG. 8, the auxiliary electrode 17A is formed on the insulating film 15 all over the substrate 11, and the auxiliary electrode 17A is selectively etched through, for example, lithography to be patterned into a predetermined shape.

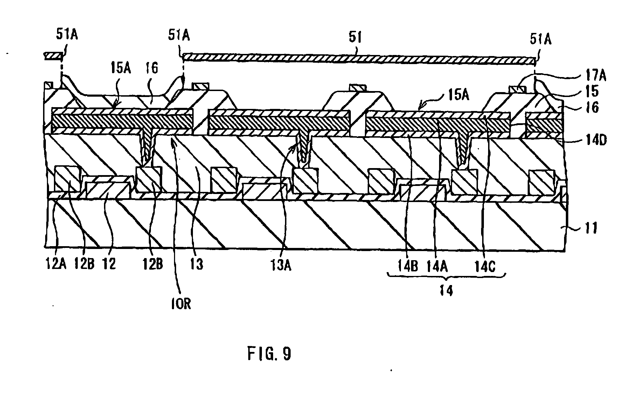

Then, as shown in FIG. 9, the hole transport layer 16A, the light-emitting layer 16B and the electron transport layer 16C of the organic light-emitting device 10R all of which are made of the above-described materials with the above-described thicknesses are formed in order through, for example, vapor deposition to form the organic layer 16 of the organic light-emitting device 10R. At this time, it is preferable that a metallic vapor deposition mask 51 having an aperture 51A corresponding to a region where the organic layer 16 is formed is used to form the organic layer 16 corresponding to the light-emitting region, that is, the aperture portion 15A of the insulating film 15. However, it is difficult to deposit the organic layer 16 only in the aperture portion 15A with high accuracy, so the whole aperture portion 15A may be covered with the organic layer 16 so as to lay the organic layer 16 on an edge of the insulating film 15.

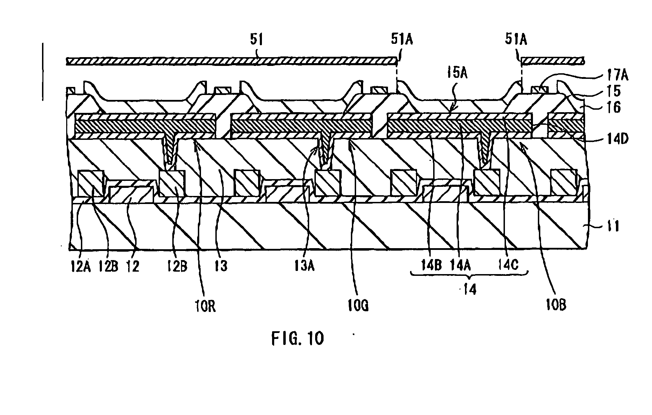

After that, the vapor deposition mask 51 is shifted, and as shown in FIG. 10, as in the case of the organic layer 16 of the organic light-emitting device 10R, the hole transport layer 16A and the light-emitting layer 16B of the organic light-emitting device 10G both made of the above-described materials with the above-described thicknesses are formed in order so as to form the organic layer 16 of the organic light-emitting device 10G. Next, the vapor deposition mask 51 is shifted again, and as shown in FIG. 10, as in the case of the organic layer 16 of the organic light-emitting device 10R, the hole transport layer 16A, the light-emitting layer 16B and the electron transport layer 16C of the organic light-emitting device 10B all of which are made of the above-described materials with the above-described thicknesses are formed in order so as to form the organic layer 16 of the organic light-emitting device 10B. FIG. 10 shows a state in which the aperture 51A of the vapor deposition mask 51 faces the organic layer 16 of the organic light-emitting device 10B.

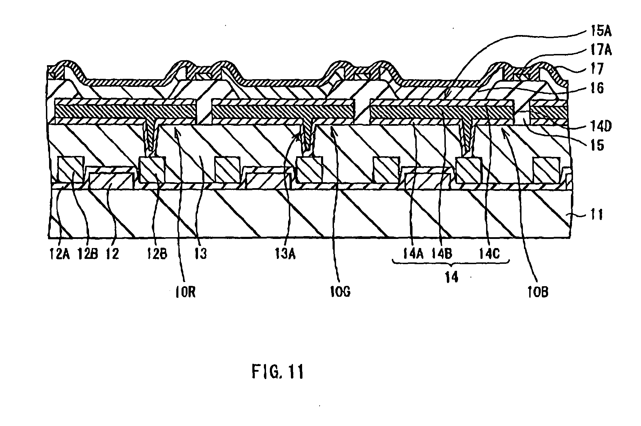

After forming the organic layer 16 of each of the organic light-emitting devices 10R, 10G and 10B, as shown in FIG. 11, the common electrode 17 made of the above-described material with the above-described thickness is formed all over the substrate 11 through, for example, vapor deposition. Thereby, the common electrode 17 is electrically connected to the auxiliary electrode 17A which has already been formed and the trunk-shaped auxiliary electrode (not shown) as a bus. Thus, the organic light-emitting devices 10R, 10G and 10B shown in FIGS. -1 through 3 are formed.

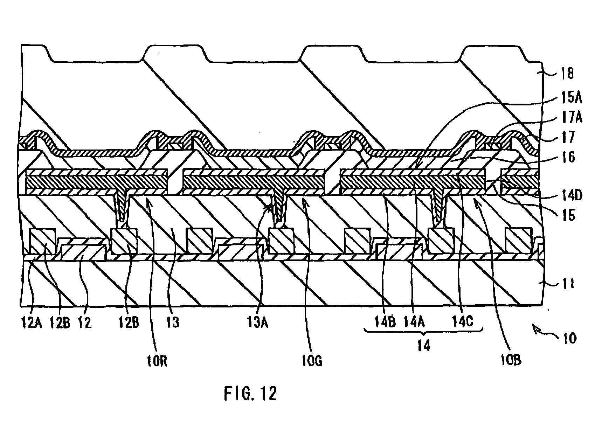

Next, as shown in FIG. 12, the protective film 18 made of the above-described material with the above-described thickness is formed on the common electrode 17. Thereby, the driving panel 10 shown in FIG. 1 is formed.

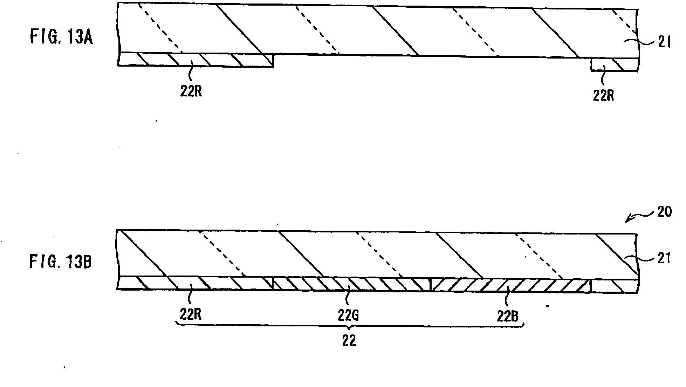

Moreover, as shown in FIG. 13A, the sealing substrate 21 made of the above-described material is coated with the material of the red filter 22R through spin coating or the like, and then the material of the red filter 22R is patterned through photolithography, and is baked so as to form the red filter 22R. Next, as shown in FIG. 13B, as in the case of the red filter 22R, the blue filter 22B and the green filter 22G are formed in order. Thereby, the sealing panel 20 is formed.

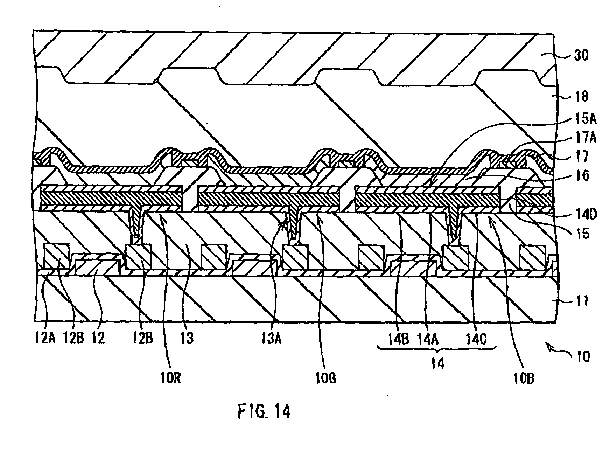

After forming the sealing panel 20 and the driving panel 10, as shown in FIG. 14, the adhesive layer 30 made of a thermosetting resin is formed through coating on a side of the substrate 11 where the organic light-emitting devices 10R, 10G and 10B are formed. The coating may be carried out through discharging the resin from a slit nozzle dispenser, or through roll coating or screen printing. Next, as shown in FIG. 1, the driving panel 10 and the sealing panel 20 are bonded together with the adhesive layer 30 in between. At this time, a surface of the sealing panel 20 where the color filter 22 is formed preferably faces the driving panel 10. Moreover, it is preferable to avoid air bubbles from entering into the adhesive layer 30. After that, relative positioning between the color filter 22 of the sealing panel 20 and the organic light-emitting devices 10R, 10G and 10B of the driving panel 10 is aligned, then heat treatment is carried out at a predetermined temperature for a predetermined time to cure the thermosetting resin of the adhesive layer 30. Thereby, the display unit shown in FIGs. 1 through 3 is completed.

In the display unit, when a predetermined voltage is applied between the laminated structure 14 and the common electrode 17, a current is injected into the light-emitting layer 16B of the organic layer 16, and holes and electrons are recombined to emit light mainly from an interface of the light-emitting layer 16B on a side closer to the hole transport layer 16A. The light is reflected several times between the first end portion P1 and the second end portion P2, and then passes through the common electrode 17 to be extracted. In the embodiment, the barrier layer 14C, the reflective layer 14A and the adhesive layer 14B are etched at once, so side etching of the reflective layer 14A can be prevented, thereby the laminated structure 14 is formed into a favorable shape. Therefore, defects in the organic light-emitting devices 10R, 10G and 10B due to a defect in the shape of the reflective layer 14A or the barrier layer 14C can be prevented, so the life of the display unit can be increased.

Thus, in the embodiment, after the adhesive layer 14B, the reflective layer 14A and the barrier layer 14C are formed in this order, they are etched at once by using the mask 41, so a defect in the shape of the reflective layer 14A or the barrier layer 14C due to side etching can be reliably prevented.

Moreover, after etching, the mask 41 is removed by using the above-described nonaqueous photoresist remover, so the remained resist on the surface of the barrier layer 14C can be eliminated, thereby corrosion of silver or the alloy including silver exposed to a side surface can be prevented, Thereby, defects in the organic light-emitting devices 10R, 10G and 10B such as a dark point defect can be reduced, and the life of the display unit can be increased. Therefore, the embodiment is specifically preferable in the case where the laminated structure 14 includes the reflective layer 14A made of silver or the alloy including silver, and the reflectance of the laminated structure 14 can be increased so as to improve the light extraction efficiency.

Further, without forming the mask 41 several times, the adhesive layer 14B, the reflective layer 14A and the barrier layer 14C are etched by using only one mask 41, so damage to the barrier layer 14C by a developing agent or the remover can be minimized, and manufacturing steps can be reduced to approximately one third of conventional manufacturing method. Therefore, the display unit having superior performance can be manufactured at low cost.

[Second Embodiment]

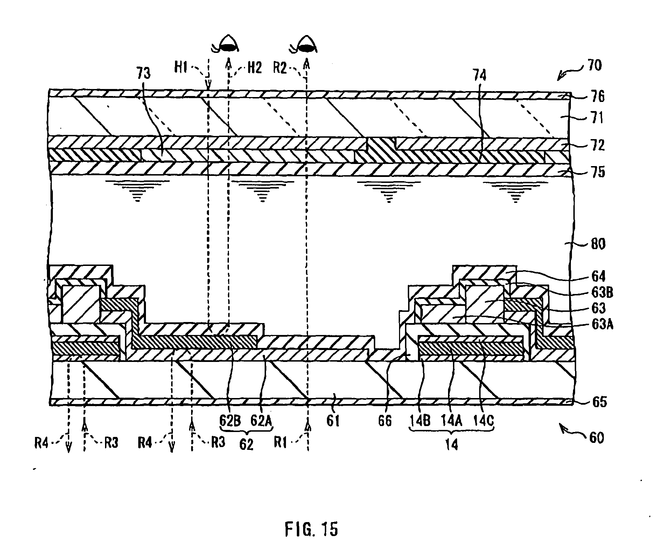

FIG. 15 shows a sectional view of a display unit according to a second embodiment of the invention. The display unit is used as a transmissive-reflective (semi-transmissive) liquid crystal display, and a drive panel 60 and an opposing panel 70 face each other, and a liquid crystal layer 80 is disposed between them.

In the drive panel 60, a pixel electrode 62 is formed in a matrix shape on a substrate 61 made of, for example, glass. On the substrate 61, an active driving circuit including a TFT 63 as a drive device electrically connected to the pixel electrode 62, wiring 63A and the like is formed. An alignment film 64 is disposed all over a surface of the substrate 61. On the other hand, a polarizing plate 65 is disposed on the other surface of the substrate 61. Moreover, the laminated structure 14 equivalent to that according to the first embodiment is disposed between the surface of the substrate 61, and the TFT 63 and the wiring 63A. An insulating film 66 is disposed between the laminated structure 14, and the TFT 63 and the wiring 63A.

The pixel electrode 62 includes, for example, a transparent electrode 62A and a reflective electrode 62B. The transparent electrode 62A is made of, for example, ITO, and the reflective electrode 62B is made of, for example, aluminum (Al) or silver (Ag). The reflective electrode 62B is formed so as to be laid over a region of the transparent electrode 62A. The region where the reflective electrode 62B is formed is a reflective display region, and a region of the transparent electrode 62A where the reflective electrode 62B is not laid is a transmissive display region.

A gate electrode (not shown) of the TFT 63 is connected to a scanning circuit (not shown), and a source (not shown) is connected to the wiring 63A as a signal line, and a drain (not shown) is connected to the pixel electrode 62. The material of the wiring 63A is the same as that of the wiring 13B in the first embodiment. Moreover, the structure of the TFT 63 is not specifically limited as in the case of the TFT 12 in the first embodiment. The TFT 63 and the wiring 63A are coated with the protective film 63B made of, for example, silicon oxide ($SiO_2$) or silicon nitride (SiN).

In the embodiment, the laminated structure 14 has a function as a reflective film for reflecting incident light which does not enter the transparent electrode 62A to return the light to a side of a backlight (not shown). The materials and the thicknesses of the adhesive layer 14B, the reflective layer 14A and the barrier layer 14C are the same as those in the first embodiment.

The alignment film 64 is made of an obliquely deposited film of silicon oxide ($SiO_2$) or the like. In this case, when a deposition angle on oblique deposition is changed, the pretilt angle of a liquid crystal layer 80 which will be described later can be controlled. As the alignment film 64, a film formed through performing a rubbing (alignment) process on an organic compound such as polyimide can be used. In this case, the pretilt angle can be controlled by changing rubbing conditions:

The polarizing plate 65 is an optical device which converts light from the backlight (not shown) into a linearly polarized light in a certain direction, and includes, for example, a polyvinyl alcohol (PVA) film.

The insulating film 66 is made of, for example, silicon oxide ($SiO_2$) As the insulating film 66, a polyimide film can be used depending upon a process.

The opposing panel 70 includes an opposed substrate 71 made of glass, and the opposed substrate 71 is positioned above the drive panel 60 with the liquid crystal layer 80 in between. On the opposed substrate 71, for example, a transparent electrode 72 and a color filter 73 are laminated in order from the opposed substrate 71 corresponding to the pixel electrode 62. Moreover, on the opposed substrate 71, a light-absorbing film 74 as a black matrix is disposed along the boundary of the color filter 73. An alignment film 75 is disposed all over the opposed substrate 71 on a side closer to the liquid crystal layer 80, and an polarizing plate 76 is disposed on the other side of the opposed substrate 71.

The transparent electrode 72 is made of, for example, ITO. The color filter 73 has the same structure as that of the color filter 22 in the first embodiment. The light-absorbing film 74 absorbs external light entering into the opposed substrate 71 or reflected external light reflected by the wiring 64 so as to improve contrast, and is made of, for example, a black resin film with an optical density of 1 to which a black colorant is added, or a thin film filter using the interference of a thin film. The thin film filter includes one or more thin layers made of metal, metal nitride or metal oxide so as to attenuate light by using the interference of the thin films. More specifically, as the thin film filter, a filter in which chromium and chromium oxide (III) ($Cr_2O_3$) are alternately laminated is cited. The alignment film 75 and the polarizing plate 76 have the same structure as the alignment film 64 and the polarizing plate 65 of the drive panel 60.

The liquid crystal layer 80 changes the alignment state by applying voltage so as to change the transmittance. When the direction where liquid crystal molecules are aligned is not uniform during driving, the contrast becomes uneven. In order to avoid uneven contrast, the liquid crystal layer 80 has a slight pretilt angle in a certain direction in advance.

The display unit can be manufactured through the following steps, for example.

At first, as in the case of the first embodiment, after the adhesive layer 14B, the reflective layer 14A and the barrier layer 41C are laminated on a flat surface 61A of the substrate 61, they are etched at once. After that, a mask is removed with the photoresist remover. Next, the insulating film 66 made of the above-described material is formed so that the laminated structure 14 is covered with the insulating film 66, and the transparent electrode 62A and the reflective electrode 62B are formed so as to form the pixel electrode 62. Next, the TFT 63 and the wiring 63A are formed on the laminated structure 14 and the insulating film 66, and they are covered with the protective film 63. After that, the alignment film 64 is formed all over the substrate 61, and a rubbing process is performed. Thereby, the drive panel 60 is formed.

Moreover, the transparent electrode 72, the light-absorbing film 74 and the color filter 73 are formed on the surface of the opposed substrate 71. Next, the alignment film 75 is formed all over the opposed substrate 71, and a rubbing process is performed. Thereby, the opposing panel 70 is formed.

Next, a sealing component (not shown) made of, for example, an epoxy resin or the like is disposed in a peripheral portion of the drive panel 60 or the opposing panel 70, and a spherical or columnar spacer (not shown) is disposed. Then, the drive panel 60 and the opposing panel 70 are aligned so that the pixel electrode 62 and the transparent electrode 72 face each other, and the sealing component is cured to bond the drive panel 60 and the opposing panel 70 together, and the liquid crystal layer 80 is injected between them so as to seal them. After that, the polarizing plates 65 and 76 are attached to the drive panel 60 and the opposing panel 70, respectively. Thus, the display unit shown in FIG. 15 is completed.

In the display unit, for example, when a predetermined voltage is applied between the pixel electrode 62 and the transparent electrode 72, the alignment state of the liquid crystal layer 80 changes, thereby the transmittance changes. Incident light R1 entered from the backlight (not shown) to the transparent electrode 62A passes through the liquid crystal layer 80 to be extracted as transmitted light R2. Moreover, incident light R3 entered from the backlight to the reflective electrode 62B or the laminated structure 14 is reflected by the reflective electrode 62B or the reflective layer 14A of the laminated structure 14, and the reflected light R4 is returned to the backlight side; however, the reflected light R4 enters the pixel electrode 62 again by a reflecting mirror (not shown) disposed on the backlight. Further, external light H1 entered from the opposing panel 70 side is reflected by the reflective electrode 62B to be extracted as reflected light H2. Herein, the barrier layer 14C, the reflective layer 14A and the adhesive layer 14B are etched at once, so side etching of the reflective layer 14A can be prevented, so without a defect in the shape of the laminated structure 14 such as a shape in which a canopy-shaped projection of the barrier layer 14C is formed around the reflective layer 14A, the laminated structure 14 is formed into a favorable shape. Therefore, for example, a broken piece of a canopy-shaped portion of the barrier layer 14C can be prevented from entering the pixel electrode 62 and the liquid crystal layer 80. Further, for example, there is no possibility that a gap in the reflective layer 14A is formed by side etching, and a chemical solution is remained in the hole, so the life of the display unit can be increased.

Thus, in the embodiment, as in the case of the first embodiment, after the adhesive layer 14B, the reflective layer 14A and the barrier layer 14C are formed in order, they are etched at once by using the mask 41, and the mask 41 is removed with the remover, so a resist remained on the reflective layer 14A or the barrier layer 14C can be reliably eliminated, and corrosion of the reflective layer 14A or the barrier layer 14C can be reliably prevented, and the life of the display unit can be increased. Moreover, as in the case of the first embodiment, the second embodiment is preferable specifically in the case where the laminated structure 14 includes the reflective layer 14A made of silver (Ag) or an alloy including silver, and the reflectance of the laminated structure 14 can be enhanced to improve usability of the backlight, and the power consumption of the display unit can be reduced. Further, the manufacturing steps can be reduced, thereby the display unit having superior performance can be manufactured at low cost.

Although the present invention is described referring to the embodiments, the invention is not specifically limited to them, and is variously modified. For example, the materials and the thicknesses of the layers, film forming methods, film forming conditions and so on are not limited to those described in the embodiments, and any other materials, any other thicknesses, any other film forming methods and any other film forming conditions may be applicable.

Moreover, for example, in the above embodiments, the case where the adhesive layer 14B and the barrier layer 14C are made of a metal compound or a conductive oxide including at least one kind selected from the group of elements consisting of indium (In), tin (Sn) and zinc (Zn), more specifically they are made of at least one kind selected from the group consisting of ITO, IZO, indium oxide ($In_2O_3$), tin oxide ($SnO_2$) and zinc oxide (ZnO) is described; however, either the adhesive layer 14B or the barrier layer 14C may be made of any material other than the above-described materials. For example, the barrier layer 14C may be made of any transparent material which has low light absorption and can be etched with the reflective layer 14A and the adhesive layer 14B at once.

Further, for example, the adhesive layer 14B can be formed through not only sputtering, but also vapor deposition, CVD, MOCVD (metal organic chemical vapor deposition), laser ablation, plating or the like. Likewise, the reflective layer 14A can be formed by not only sputtering, but also vapor deposition, CVD, MOCVD, laser ablation, plating or the like.

In addition, in the first embodiment, the structures of the organic light-emitting devices 10R, 10G and 10B are described in detail; however, each of them does not necessarily include all layers such as the insulating film 15, the auxiliary electrode 17A and the protective film 18, and each of them may further include any other layer. Further, although the invention can be applied to the case where the common electrode 17 is not a semi-transparent electrode but a transparent electrode, and the common electrode 17 does not have a resonator structure, the invention is to enhance the reflectance in the laminated structure 14, so in the case where an interface between the reflective layer 14A and the barrier layer 14C of the laminated structure 14 and an interface of the common electrode 17 on a side closer to the light-emitting layer 16B are the first end portion P1 and the second end portion P2 respectively, and the organic layer 16 and the barrier layer 14C have a resonator structure as a resonant portion, higher effects can be obtained.

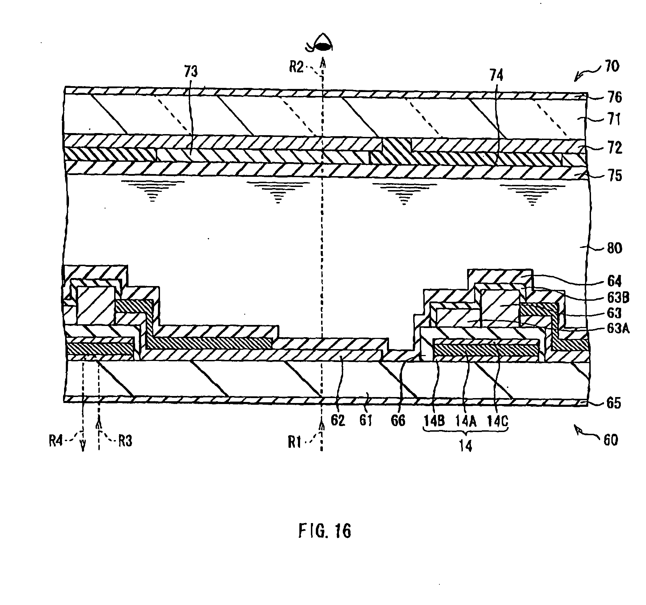

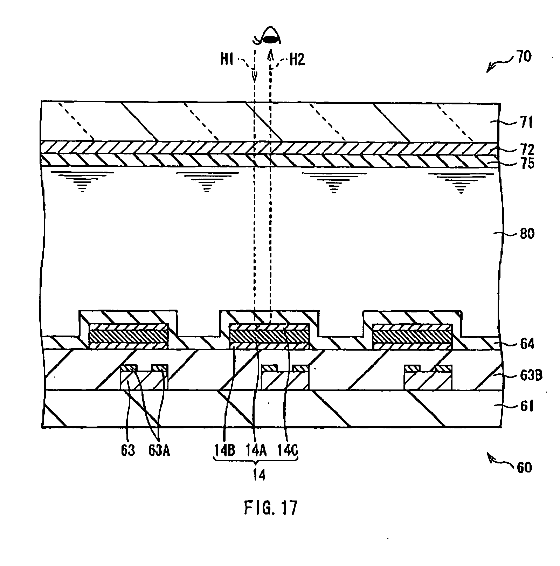

Further, in the second embodiment, the transmissive-reflective liquid crystal display is described as an example; however, the invention is applicable to any other liquid crystal displays. For example, as shown in FIG. 16, in a transmissive liquid crystal display, the laminated structure 14 may be disposed as a reflective film. Further, as shown in FIG. 17, the laminated structure 14 may be used as a reflective pixel electrode. Still further, in the second embodiment, the laminated structure 14 may be disposed instead of the reflective electrode 62B or the wiring 63A.

In addition, in the second embodiment, the structure of the liquid crystal display device is described in detail; however, all layers or components are not necessarily included, and any other layer or component may be further included.

Moreover, in the above embodiments, the case where the invention is applied to the display unit such as the organic light-emitting display unit or the liquid crystal display unit; however, for example, the laminated structure according to the invention can be applied as not only a reflective electrode or a reflective film but also metal wiring by using an advantage that the reflective layer 14A has low resistance. Thereby, the corrosion of silver can be prevented, and metal wiring having superior performance can be achieved.

Further, the display device according to the invention, specifically the organic light-emitting device is not specifically applied to the display unit, and can be applied to illumination which is not for a display.

As described above, in the method of manufacturing the laminated structure according to the invention and the laminated structure according to the invention, after a plurality of layers are formed, they are etched at once by using the same mask, so a defect in shape due to side etching can be prevented, and cost reduction can be achieved by a reduction in the manufacturing steps.

Obviously many modifications and variations of the present invention are possible in the light of the above teachings. It is therefore to be understood that within the scope of the appended claims the invention may be practiced otherwise than as specifically described.

**Claims**

1. A method of manufacturing a laminated structure, comprising the steps of:

    laminating a plurality of layers on a substrate;
    forming a mask on the plurality of layers; and
    etching the plurality of layers at once by using the mask.

2. A method of manufacturing a laminated structure according to claim 1, wherein
    as a layer among the plurality of layers, a silver layer made of silver (Ag) or an alloy including silver is formed.

3. A method of manufacturing a laminated structure according to claim 2, wherein
    the step of forming the plurality of layers includes the steps of:

    forming an adhesive layer on the substrate;
    forming the silver layer in contact with a surface of the adhesive layer; and
    forming a barrier layer for protecting the silver layer in contact with a surface of the silver layer.

4. A method of manufacturing a laminated structure according to claim 3, wherein
    at least either the adhesive layer or the barrier layer is made of a metal compound or a conductive oxide including at least one kind selected from the group of elements consisting of indium (In), tin (Sn) and zinc (Zn).

5. A method of manufacturing a laminated structure according to claim 3, wherein
    at least either the adhesive layer or the barrier layer is made of at least one kind selected from the group consisting of a compound including indium (In), tin (Sn) and oxygen (O), a compound including indium (In), zinc (Zn) and oxygen (O), indium oxide $(In_2O_8)$, tin oxide $(SnO_2)$ and zinc oxide (ZnO).

6. A method of manufacturing a laminated structure according to claim 4, wherein
    the adhesive layer and the barrier layer include at least one common element selected from the group consisting of indium (In), tin (Sn) and zinc (Zn).

7. A method of manufacturing a laminated structure according to claim 6, wherein
    the adhesive layer and the barrier layer both include at least indium (In).

8. A method of manufacturing a laminated structure according to claim 7 wherein
    the adhesive layer and the barrier layer are made of a compound including indium, tin and oxygen.

9. A method of manufacturing a laminated structure according to claim 7, wherein
    the adhesive layer is made of a compound including indium, tin and oxygen, and the barrier layer is made of a compound including indium, zinc and oxygen.

10. A method of manufacturing a laminated structure according to claim 7, wherein
    the adhesive layer and the barrier layer are made of a compound including indium, zinc and oxygen.

**11.** A method of manufacturing a laminated structure according to claim 4, wherein

in the step of etching the plurality of layers at once, dry etching is performed by using an etching gas including a component capable of forming a volatile compound with all of the plurality of layers.

**12.** A method of manufacturing a laminated structure according to claim 11, wherein

the etching gas includes methane ($CH_4$).

**13.** A method of manufacturing a laminated structure according to claim 2, further comprising the step of:

removing the mask with a remover.

**14.** A method of manufacturing a laminated structure according to claim 13, wherein

the remover includes an organic amino compound including at least one kind selected from the group consisting of diethylenetriamine, 2-(2-aminoethylamino)ethanol, 2-(2-aminoethylamino)-2propanol, N-(3-aminopropyl)-N-(2-hydxoxyethyl)-2-aminoethanol, 2-(2-aminoethoxy)ethanol, dipropylenetriamine, triethylenetetramine and formalin, and one kind or two or more kinds of polar organic solvents, and the remover is nonaqueous.

**15.** A method of manufacturing a laminated structure according to claim 13, wherein

the remover further includes an anti corrosive.

**16.** A method of manufacturing a laminated structure according to claim 14, wherein

the total content of the organic amino compound in the remover is within a range of 20% by mass to 50% by mass inclusive.

**17.** A method of manufacturing a laminated structure according to claim 14, wherein

the polar organic solvent in the remover includes at least one kind selected from the group consisting of 1,3-dimethyl-2-imidazolidinone and N-methyl-2-pyrzolidinone.

**18.** A laminated structure, formed through forming an adhesive layer, a silver layer made of silver or an alloy including silver and a barrier layer in order on a substrate, forming a mask on the barrier layer, and etching the barrier layer, the silver layer and the adhesive layer at once by using the mask.

**19.** A laminated structure according to claim 18, wherein

at least either the adhesive layer or the barrier layer is made of a metal compound or a conductive oxide including at least one kind selected from the group of elements consisting of indium, tin and zinc.

**20.** A laminate according to claim 19, wherein

at least either the adhesive layer or the barrier layer is made of at least one kind selected from the group consisting of a compound including indium, tin and oxygen, a compound including indium, zinc and oxygen, indium oxide ($In_2O_3$), tin oxide ($SnO_2$) and zinc oxide (ZnO).

**21.** A laminated structure according to claim 19, wherein

the adhesive layer and the barrier layer include at least one common element selected from the group consisting of indium, tin and zinc.

**22.** A laminated structure according to claim 21, wherein

the adhesive layer and the barrier layer both include at least indium.

**23.** A laminated structure according to claim 21, wherein

the adhesive layer and the barrier layer are made of a compound including indium, tin and oxygen.

**24.** A laminated structure according to claim 21, wherein

the adhesive layer is made of a compound including indium, tin and oxygen, and the barrier layer is made of a compound including indium, zinc and oxygen.

**25.** A laminated structure according to claim 21, wherein

the adhesive layer and the barrier layer are made of a compound including indium, zinc and oxygen.

**26.** A display device, comprising:

a laminated structure formed through forming an adhesive layer, a silver layer made of silver or an alloy including silver and a barrier layer in order on a substrate, forming a mask on the barrier layer, and etching the barrier layer, the silver layer and the adhesive layer at once by using the mask.

**27.** A display device according to claim 26, wherein

the display device is an organic light-emitting device in which an organic layer including a light-emitting layer and an electrode are laminated in order on the laminated structure, and light generated in the light-emitting layer is extracted from the electrode side of the organic light-emitting device.

**28.** A display device according to claim 26, wherein

the display device is a liquid crystal display device in which a pixel electrode, and a drive device and wiring electrically connected to the pixel electrode are disposed on the substrate, and the laminated structure is disposed between the substrate, and the drive device and the wiring.

29. A display device according to claim 26, wherein the display device is a liquid crystal display device in which a pixel electrode including a reflective electrode is disposed on the substrate, and the reflective electrode is the laminated structure.

30. A display unit, comprising:

a plurality of display devices on a substrate,

wherein each of the display devices comprises a laminated structure formed through forming an adhesive layer, a silver layer made of silver or an alloy including silver and a barrier layer in order on a substrate, forming a mask on the barrier layer, and etching the barrier layer, the silver layer and the adhesive layer at once by using the mask.

31. A display unit according to claim 30, wherein each of the display devices is an organic light-emitting device in which an organic layer including a light-emitting layer and an electrode are laminated in order on the laminated structure, and light generated in the light-emitting layer is extracted from the electrode side of the organic light-emitting device.

32. A display unit according to claim 30, wherein each of the display devices is a liquid crystal display device in which a pixel electrode, and a drive device and wiring electrically connected to the pixel electrode are disposed on the substrate, and the laminated structure is disposed between the substrate, and the drive device and the wiring.

33. A display unit according to claim 30, wherein each of the display devices is a liquid crystal display device in which a pixel electrode including a reflective electrode is disposed on the substrate, and the reflective electrode is the laminated structure.

FIG. 1

EP 1 482 572 A1

10R, 10B

P2

17
16C
16B 16
16A
17A
15
14C
14A 14
14B
13
L
P1

12B

FIG. 2

10G

P2

17
16B 16
16A
17A
15
14C
14A 14
14B
13
L
P1

12B

FIG. 3

FIG. 4A

12A 12B 12　12B

~11

FIG. 4B

12A 12B 12　12B　13　　　13A

~11

EP 1 482 572 A1

FIG. 5A

12A 12B 12    12B    13    13A    14B    11

FIG. 5B

12A 12B 12    12B    13    13A    14B 14A    11

FIG. 5C

12A 12B 12    12B    13    13A    14B 14A    14C    11

EP 1 482 572 A1

19

FIG. 6A

FIG. 6B

FIG. 7A

14D

11

12A 12B 12   12B   13     13A        14B 14A 14C
14

FIG. 7B

15A        15
14D

11

12A 12B 12   12B   13     13A        14B 14A 14C
14

FIG. 8

FIG. 9

EP 1 482 572 A1

51    51A    51A

17A
15
16
15A
14D

12A 12B 12    12B    13    13A    14B 14A    14C
                                        14

10R         10G              10B

FIG. 10

FIG. 11

EP 1 482 572 A1

FIG. 12

FIG. 13A

FIG. 13B

FIG. 14

FIG. 15

FIG. 16

FIG. 17

EP 1 482 572 A1

**European Patent Office**

## EUROPEAN SEARCH REPORT

Application Number

EP 04 01 2595

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 733 931 A (TOPPAN PRINTING CO LTD) 25 September 1996 (1996-09-25) | 1-7,13, 15, 18-22, 26, 28-30, 32,33 | H01L51/10 H01L21/28 G09G3/32 H05B33/26 G02F1/1343 |
| Y | * the whole document * <br><br> * page 3, line 46 - page 6, line 10 * <br> * page 6, line 41 - line 42 * <br> * figure 1 * | 9,10, 23-25 | |
| X | US 2001/026120 A1 (IMAYOSHI KOJI ET AL) 4 October 2001 (2001-10-04) | 1-3,11, 13,15, 18,26, 28-30, 32,33 | |
| Y | * the whole document * <br><br> * paragraphs [0070], [0071] * <br> * figures 1,2,5 * | 9,10, 23-25 | TECHNICAL FIELDS SEARCHED (Int.Cl.7) |
| X | FR 2 745 955 A (UNIV PRINCETON) 12 September 1997 (1997-09-12) | 1-5,11, 13,15, 18-22, 26,27, 30,31 | H01L G09G H05B G02F C23F |
| Y | * page 18, line 5 - page 22, line 30 * <br><br> * page 28, line 6 - line 15 * <br> * figure 12 * | 9,10, 23-25 | |
| X | US 6 081 310 A (FUJII TOMOKO ET AL) 27 June 2000 (2000-06-27) * column 3, line 35 - column 7, line 36 * * figure 6 * | 1,2,13, 15,18 | |

-/--

The present search report has been drawn up for all claims

| Place of search | Date of completion of the search | Examiner |
|---|---|---|
| Munich | 27 August 2004 | Bernabé Prieto, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**European Patent Office**

## EUROPEAN SEARCH REPORT

Application Number

EP 04 01 2595

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 158 344 A (SEIKO EPSON CORP) 28 November 2001 (2001-11-28) | 1,2 | |
| Y | * paragraphs [0012], [0013], [0093] - [0102] * * figure 13 * | 23 | |
| X | US 2002/195435 A1 (RAM JYOTHSNA ET AL) 26 December 2002 (2002-12-26) | 26,28,29 | |
| Y | * figure 1; table 1 * | 23 | |
| X | PATENT ABSTRACTS OF JAPAN vol. 2003, no. 04, 2 April 2003 (2003-04-02) -& JP 2002 365664 A (MATSUSHITA ELECTRIC IND CO LTD), 18 December 2002 (2002-12-18) * abstract * * paragraphs [0032] - [0043] * * figure 1 * | 1,2 | |
| Y | PATENT ABSTRACTS OF JAPAN vol. 017, no. 413 (C-1092), 3 August 1993 (1993-08-03) -& JP 05 085783 A (ASAHI GLASS CO LTD), 6 April 1993 (1993-04-06) * abstract * * figures 1-3 * | 9,10, 23-25 | TECHNICAL FIELDS SEARCHED (Int.Cl.7) |

The present search report has been drawn up for all claims

| Place of search | Date of completion of the search | Examiner |
|---|---|---|
| Munich | 27 August 2004 | Bernabé Prieto, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 04 01 2595

This annex lists the patent family members relating to the patent documents cited in the above-mentioned European search report.
The members are as contained in the European Patent Office EDP file on
The European Patent Office is in no way liable for these particulars which are merely given for the purpose of information.

27-08-2004

| Patent document cited in search report | | Publication date | Patent family member(s) | | Publication date |
|---|---|---|---|---|---|
| EP 0733931 | A | 25-09-1996 | DE | 69629613 D1 | 02-10-2003 |
| | | | DE | 69629613 T2 | 17-06-2004 |
| | | | EP | 0733931 A2 | 25-09-1996 |
| | | | JP | 2985763 B2 | 06-12-1999 |
| | | | JP | 9123337 A | 13-05-1997 |
| | | | JP | 3191704 B2 | 23-07-2001 |
| | | | JP | 9183181 A | 15-07-1997 |
| | | | JP | 3427648 B2 | 22-07-2003 |
| | | | JP | 9230806 A | 05-09-1997 |
| | | | JP | 2003154598 A | 27-05-2003 |
| | | | TW | 496985 B | 01-08-2002 |
| | | | US | 5667853 A | 16-09-1997 |
| US 2001026120 | A1 | 04-10-2001 | JP | 11282383 A | 15-10-1999 |
| | | | TW | 409261 B | 21-10-2000 |
| | | | US | 6249082 B1 | 19-06-2001 |
| FR 2745955 | A | 12-09-1997 | US | 5703436 A | 30-12-1997 |
| | | | AT | 246845 T | 15-08-2003 |
| | | | AU | 2278197 A | 22-09-1997 |
| | | | CA | 2248283 A1 | 12-09-1997 |
| | | | CN | 1215500 A ,B | 28-04-1999 |
| | | | DE | 69723964 D1 | 11-09-2003 |
| | | | DE | 69723964 T2 | 17-06-2004 |
| | | | EP | 0885451 A1 | 23-12-1998 |
| | | | ES | 2157694 A1 | 16-08-2001 |
| | | | FR | 2745955 A1 | 12-09-1997 |
| | | | ID | 16137 A | 04-09-1997 |
| | | | IT | MI970488 A1 | 07-09-1998 |
| | | | JP | 2000507029 T | 06-06-2000 |
| | | | WO | 9733296 A1 | 12-09-1997 |
| | | | US | 2003213967 A1 | 20-11-2003 |
| | | | US | 2002153243 A1 | 24-10-2002 |
| | | | US | 2001000005 A1 | 15-03-2001 |
| | | | US | 6264805 B1 | 24-07-2001 |
| US 6081310 | A | 27-06-2000 | JP | 11218751 A | 10-08-1999 |
| | | | TW | 439150 B | 07-06-2001 |
| EP 1158344 | A | 28-11-2001 | JP | 3384397 B2 | 10-03-2003 |
| | | | JP | 2002049032 A | 15-02-2002 |
| | | | CN | 1335531 A | 13-02-2002 |
| | | | EP | 1158344 A2 | 28-11-2001 |
| | | | JP | 2002049035 A | 15-02-2002 |
| | | | US | 2002005928 A1 | 17-01-2002 |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 04 01 2595

This annex lists the patent family members relating to the patent documents cited in the above-mentioned European search report.
The members are as contained in the European Patent Office EDP file on
The European Patent Office is in no way liable for these particulars which are merely given for the purpose of information.

27-08-2004

| Patent document cited in search report | | Publication date | Patent family member(s) | | Publication date |
|---|---|---|---|---|---|
| US 2002195435 | A1 | 26-12-2002 | US | 6485839 B1 | 26-11-2002 |
| | | | AU | 4712400 A | 05-12-2000 |
| | | | CN | 1350658 T | 22-05-2002 |
| | | | EP | 1183570 A1 | 06-03-2002 |
| | | | JP | 2002544568 T | 24-12-2002 |
| | | | WO | 0070405 A1 | 23-11-2000 |
| JP 2002365664 | A | 18-12-2002 | NONE | | |
| JP 05085783 | A | 06-04-1993 | JP | 3226953 B2 | 12-11-2001 |
| | | | DE | 69230189 D1 | 02-12-1999 |
| | | | DE | 69230189 T2 | 10-02-2000 |
| | | | EP | 0499950 A2 | 26-08-1992 |
| | | | US | 5346770 A | 13-09-1994 |

EPO FORM P0459

For more details about this annex : see Official Journal of the European Patent Office, No. 12/82